# EUROPEAN PATENT APPLICATION

(11) **EP 2 453 497 A1**
(43) Date of publication of application: **16.05.2012**
(21) Application number: 10191120.4
(22) Date of filing: 12.11.2010
(51) Int. Cl.: H01L 51/52, G09F 13/22

(54) **Icon organic light emitting diode display with high uniformity and increased brightness**

(71) Applicant: Winstar Display Co., Ltd., Taichung City (TW)
(72) Inventor: Liao, Yu Pin, Taichung City (TW); Liu, Ying Ju, Taichung City (TW); Chan, Mao Yuan, Taichung City (TW)
(74) Representative: Chaillot, Geneviève

(57) **Abstract**

An icon organic light emitting diode (OLED) display with high uniformity and increased brightness has a driving module (16), an OLED display module (12) and multiple power control modules (14). The driving module (16) is connected to the power control modules (14). The power control modules (14) generate multiple direct current (DC) powers. The OLED display module (12) has multiple OLED units (123) having multiple non-identical shapes and sizes. Each OLED unit is driven by one DC power based on the shape and size of the OLED unit. The OLED units (123) with different sizes and shapes are driven respectively by proper DC powers, thus increased brightness and high uniformity of the OLED display is achieved.

## Description

### 1. Field of Invention

The present invention relates to an organic light emitting diode display that has high display uniformity and brightness.

### 2. Description of the Related Art

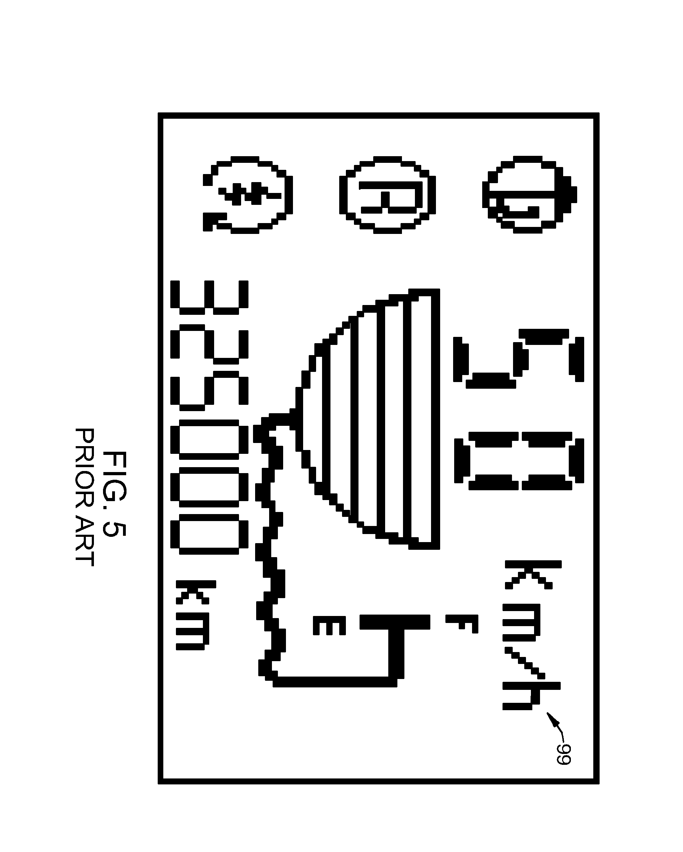

Compared to other Flat Panel displays, an organic light emitting diode (OLED) display is light weight and thinner and has higher power efficiency, which makes it very important to the future display market. Furthermore, the OLED display is a self-emission display that decreases power waste and reduces structural complexity. Although the OLED has good performance in many fields, some problems remain to be solved, which limits the conventional OLED display market. With reference to Fig. 5, conventional OLED displays are normally dot matrixes to display complex pictures. The dot matrix OLED display has to be driven by an alternative square wave, which has disadvantages of poor display quality, limited OLED life and low process yield.

Display quality of dot matrix OLED displays is always bad and not smooth since display content is formed by dots (pixels). Zigzag edges (99) appear in characters and figures displayed with conventional OLED displays.

Resolution of OLED displays may be improved by increasing dots in the OLED display, but the life of the OLED display decreases. When the resolution of the OLED display is increased, voltage of each square pulse of the alternative square wave has to be increased to maintain brightness of the OLED display.

However, brightness is decreased by the increased resolution since a scanning period (working duty) of each dot in a frame is decreased. Thus, the increased voltage overloads the OLED display since the square pulse is very narrow with very high voltage, which easily to breaks down the OLED display.

Process yield is low because the dot matrix OLED display includes too many switching elements adjacent to dots in the display.

The present invention provides an icon organic light emitting diode display with high uniformity and increased brightness to overcome shortcomings of a conventional OLED display.

The primary objective of the present invention is to provide an icon organic light emitting diode display having high displaying uniformity and increased brightness.

The icon organic light emitting diode (OLED) display with high uniformity and increased brightness has a driving module (16), an OLED display module (12) and multiple power control modules (14). The OLED display module (12) has multiple OLED units (123). The OLED units (123) have different shapes and sizes. The power control modules (14) are connected to the driving module (16) and generate multiple direct current (DC) powers. DC power based on the shape and size of the OLED unit drives each OLED unit. Proper DC power respectively drives OLED units (123) with different sizes and shapes, thus increased brightness and uniformity of the OLED display is achieved.

The present invention therefore relates to an icon organic light emitting diode (OLED) display with high uniformity and increased brightness having a front and characterized in that the icon OLED display comprises a driving module, an OLED display module and multiple power control modules, the driving module receiving a display signal and transforming the display signal to a driving signal; the OLED display module comprising a substrate, multiple OLED units and a top cover, where the substrate has an edge and an inner surface, the multiple OLED units are mounted on the inner surface of the substrate and comprises multiple different shapes and sizes, at least one of the shapes and sizes comprising a curved edge and being activated respectively by multiple direct current (DC) powers to emit visible light, and the top cover having an inner surface, being mounted on the substrate with a sealing unit being mounted on the edge of the substrate to seal the OLED units between the substrate; and each power control module being connected to the driving module, receiving a driving signal from the driving module and generating DC power based on the driving signal, and each power control module being connected to the at least one OLED unit and providing DC power to the connected OLED unit.

Other objectives, advantages and novel features of the invention will become more apparent from the following detailed description when taken in conjunction with the accompanying drawings.

### IN THE DRAWINGS

Fig. 1 is an icon displayed on an organic light emitting diode (OLED) display with high uniformity and increased brightness in accordance with the present invention;
Fig. 2 is a block diagram of the icon OLED display with high uniformity and increased brightness in accordance with the present invention;
Fig. 3A is a cross-sectional side view of the icon OLED display in Fig. 2;
Fig. 3B is a side view of layers of the icon OLED display in Fig. 2;
Fig. 4 is a circuit diagram of a voltage control unit of the icon OLED display in Fig. 2;
Fig. 5 is an icon displayed on a conventional OLED.

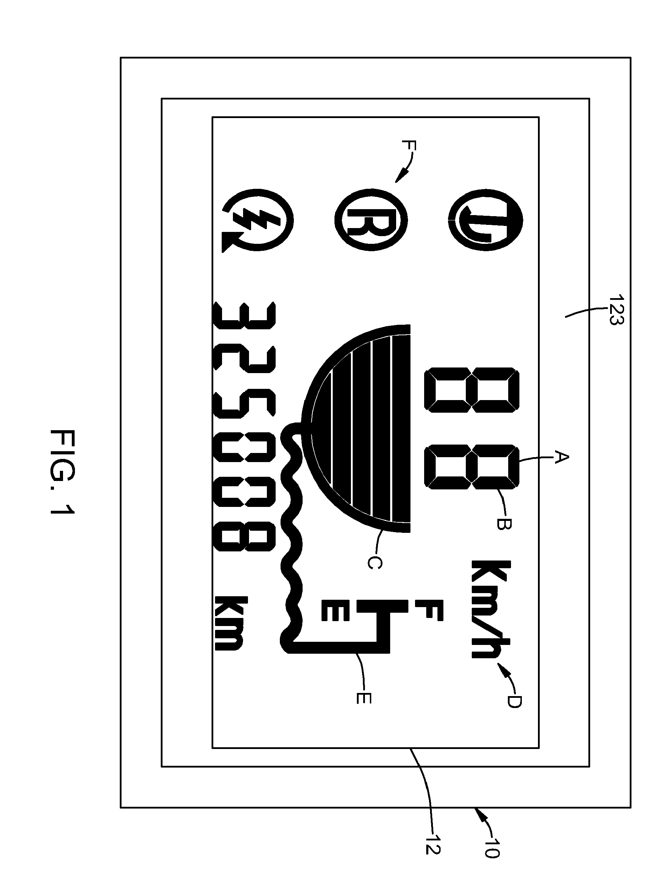

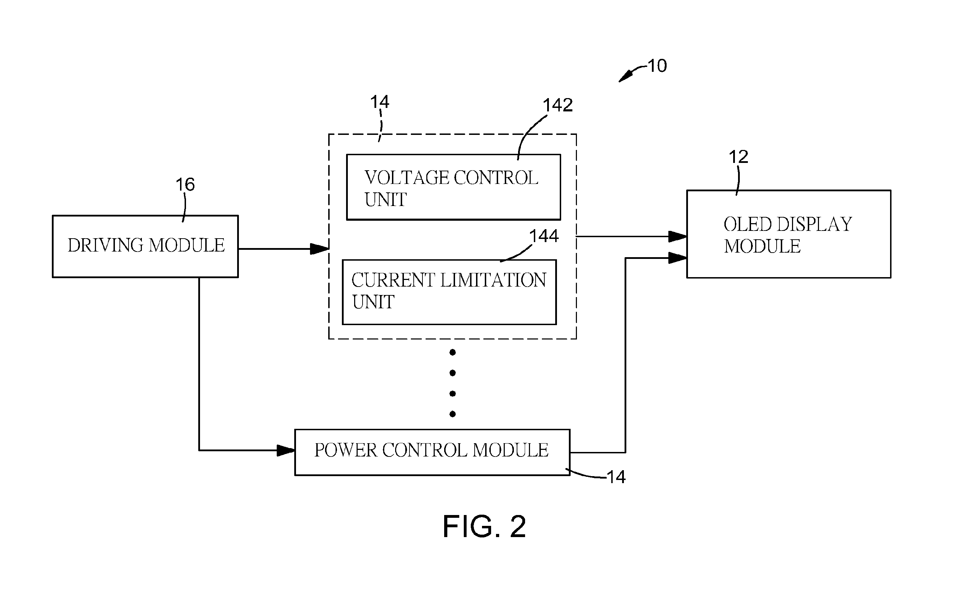

With reference to Figs. 1 and 2, an icon organic light emitting diode (OLED) display with high uniformity and increased brightness (10) in accordance with the present invention has a front and comprises a driving module (16), an OLED display module (12) and multiple power control modules (14).

The driving module (16) receives a display signal from an image source and transforms the display signal to a driving signal.

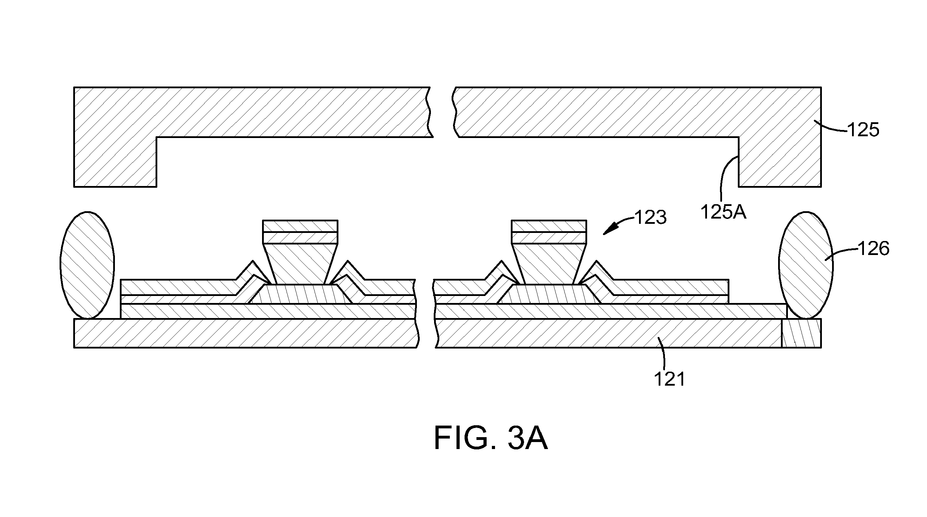

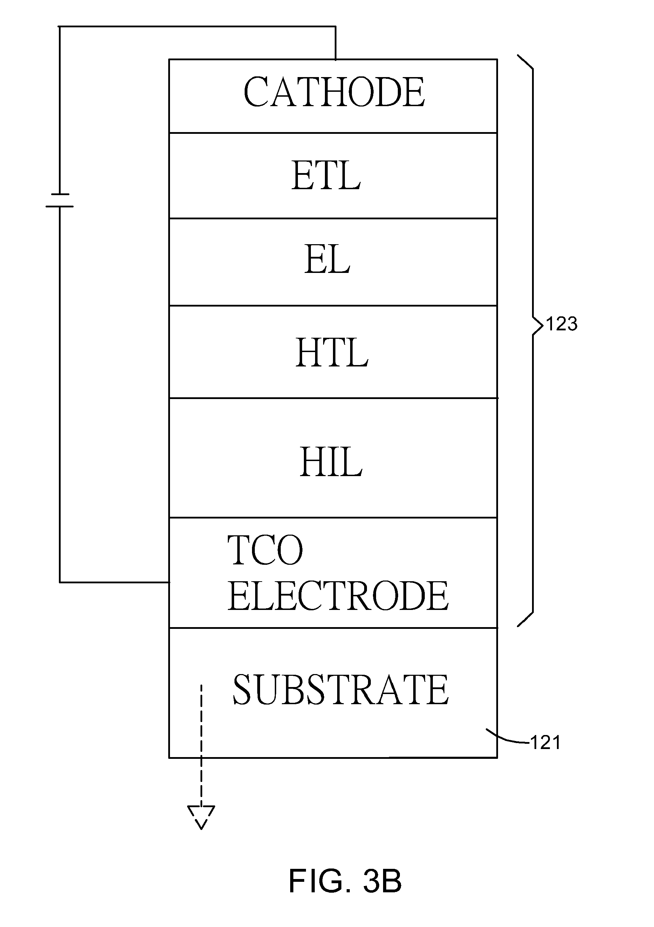

With further reference to Figs. 3A and 3B, the OLED display module (12) comprises a substrate (121), multiple OLED units (123) and a top cover (125). The substrate (121) has an edge and an inner surface and may be a glass plate.

The OLED units (123) are mounted on the inner surface of the substrate (121), and each OLED unit (123) may be a transparent conductive oxide (TCO) electrode, a hole injection layer (HIL), a hole transport layer (HTL), an emitting layer (EL), an electron transport layer (ETL) and a cathode. The TCO electrode may be indium tin oxide, indium zinc oxide or similar metal oxides. The HIL has a thickness between 500A (500nm) to 5000A (500nm). From results of a test of life, a thicker HIL may cover non-uniform surface structures (e.g. spikes) on the TCO electrode so as to reduce field emission effect from these spikes and extends life of the OLED unit (123). Reduced brightness of the OLED unit (123) caused by the increased thickness of the HIL may be easily solved by increasing the DC power in the present invention. The HIL, the hole transport layer, the emitting layer and the electron transport layer are organic materials. The cathode may be aluminum.

The OLED units (123) comprise different shapes and sizes when viewed from the front. At least one of the different shapes of the OLED units (123) has a curved edge. The curved edge may be part of an Arabic numeral, a character (D), a line (E) or a figure (C, F). The OLED units (123) are activated respectively by multiple direct current (DC) powers to emit uniformly visible light. Application of different DC powers to the OLED units (123) is based on the sizes of the OLED units (123), so the OLED units (123) may emit visible light with uniform brightness since each OLED unit (123) is activated directly by a proper DC power. The life of each OLED unit (123) is also extended since the DC power replaces a high frequency pulse driving power to reduce breakdown of the OLED unit (123).

The top cover (125) has an inner surface, may be a flat plate and may have a recess (125A) formed on the inner surface of the top cover (125). The top cover (125) is mounted on the substrate (121) with a sealing unit (126). The sealing unit (126) is mounted on the edge of the substrate. The recess (125A) improves the process yields since the recess (125A) provides a gap between the top cover (125) so the OLED units (123) is not easily damaged by the top cover (125) during the mounting process of the top cover (125) and the substrate (121). The recess (125A) may further have a moisture absorbent mounted in the recess (125A) to prevent moisture from being sealed between the substrate (121) and top cover (125) and preventing moisture damage to the OLED unit (123).

Each power control module (14) is connected to the driving module (16), receives a driving signal from the driving module (16) and generates DC power based on the driving signal. Each power control module (14) is connected to at least one OLED unit (123) and provides DC power to the OLED unit (123). Since each OLED unit (123) is activated by one control module (14) that provides the proper DC power, the brightness of the emitted light from the OLED units (123) is uniform.

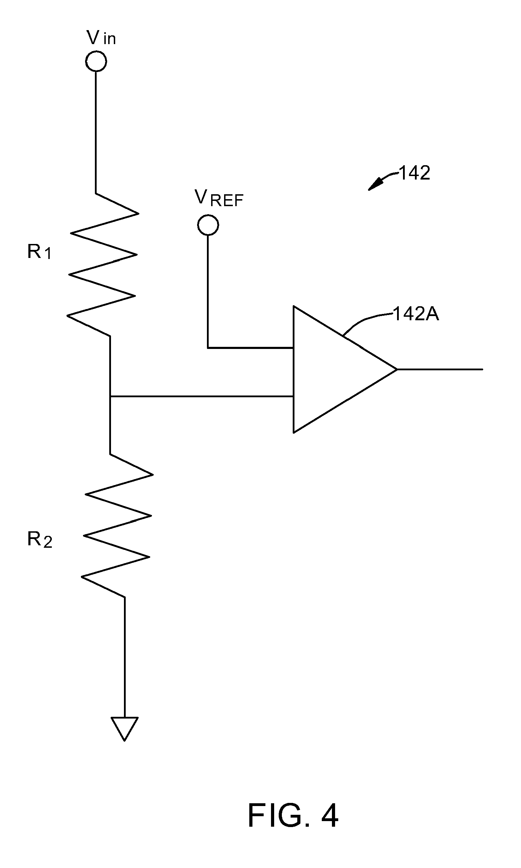

With further reference to Fig. 2 and Fig. 4, the power control module (14) may have a voltage control unit (142) and a current limitation unit (144). The voltage control unit (142) and the current limitation unit (144) are used to control DC power properly for the OLED unit (123) to which the power control module (14) is connected. The voltage control unit (142) may have a comparator (142A), a reference voltage (V_{REF}) and a voltage dividing circuit (Vᵢₙ, R₁, R₂). The reference voltage (V_{REF}) and the voltage dividing circuit (Vᵢₙ, R₁, R₂) are inputs to the comparator (142A). By adjusting the reference voltage (V_{REF}) and the voltage dividing circuit (Vᵢₙ, R₁, R₂), DC powers with different voltage drops for proper OLED units (123) may be controlled by the comparator (142A).

The OLED display in accordance with the present invention has numerous advantages.
1) The OLED units (123) may be shaped like figures with curved edges. The display quality of the OLED display module (12) is improved since no discontinuous edges exist in the present invention.
2) Each OLED unit (123) is driven by a proper DC power, so the brightness and life are improved since each OLED unit (123) is lighted all the time instead of frame scanning as in a conventional dot matrix OLED. The uniformity of the OLED display module (12) is also improved since the OLED units (123) are driven independently by proper DC powers.
3) Process yield is improved by the recess (125A) in the top cover (125) and a simplified interior structure that has fewer switches in the OLED display module (12).

## Claims

1. An icon organic light emitting diode (OLED) display with high uniformity and increased brightness (10) having a front and **characterized in that** the icon OLED display comprises a driving module (16), an OLED display module (12) and multiple power control modules (14), the driving module (16) receiving a display signal and transforming the display signal to a driving signal; the OLED display module (12) comprising a substrate (121), multiple OLED units (123) and a top cover (125), where the substrate (121) has an edge and an inner surface, the multiple OLED units (123) are mounted on the inner surface of the substrate (121) and comprises multiple different shapes and sizes, at least one of the shapes and sizes comprising a curved edge and being activated respectively by multiple direct current (DC) powers to emit visible light, and the top cover (125) having an inner surface, being mounted on the substrate (121) with a sealing unit (126) being mounted on the edge of the substrate (121) to seal the OLED units (123) between the substrate (121); and each power control module (14) being connected to the driving module (16), receiving a driving signal from the driving module (16) and generating DC power based on the driving signal, and each power control module (14) being connected to the at least one OLED unit (123) and providing DC power to the connected OLED unit (123).

2. The icon OLED display as claimed in claim 1, wherein each OLED unit (123) is a transparent conductive oxide electrode, a hole injection layer, a hole transport layer, an emitting layer, an electron transport layer and a cathode, where the hole injection layer, a hole transport layer, an emitting layer, an electron transport layer are organic materials and the cathode is aluminum.

3. The icon OLED display as claimed in claim 1, wherein the top cover (125) comprises a recess (125A) formed on the inner surface.

4. The icon OLED as claimed in claim 1, wherein DC power to the OLED unit (123) is based on the size and the area of the OLED unit (123).

5. The icon OLED display as claimed in claim 2, wherein the hole injection layer has a thickness of between 500A to 5000A.

6. The icon OLED display as claimed in claim 2, wherein the top cover (125) comprises a recess (125A) formed in the inner surface.

7. The icon OLED display as claimed in claim 3, wherein the recess (125A) has a moisture absorbent mounted in the recess (125A).

8. The icon OLED display as claimed in claim 6, wherein a moisture absorbent is mounted in the recess (125A).

9. The icon OLED display as claimed in claim 7, wherein the DC power to the OLED unit (123) is based on the size and the area of the OLED unit (123).

10. The icon OLED display as claimed in claim 9, wherein the curved edge is part of an Arabic numeral, a character, a line or a figure.
